# FASCICULE DE BREVET EUROPEEN

(11) **EP 3 563 426 B1**
(45) Date de publication et mention de la délivrance du brevet: **18.11.2020**
(21) Numéro de dépôt: 17832293.9
(22) Date de dépôt: 22.12.2017
(51) Int. Cl.: H01L 33/00

(54) **PROCEDE DE REALISATION D'UN DISPOSITIF OPTOELECTRONIQUE COMPORTANT UNE ETAPE DE GRAVURE DE LA FACE ARRIERE DU SUBSTRAT DE CROISSANCE**
VERFAHREN ZUR HERSTELLUNG EINER OPTOELEKTRONISCHEN VORRICHTUNG MIT EINEM SCHRITT ZUM ÄTZEN DER RÜCKSEITE DES WACHSTUMSSUBSTRATS
METHOD FOR PRODUCING AN OPTOELECTRONIC DEVICE COMPRISING A STEP OF ETCHING THE REAR FACE OF THE GROWTH SUBSTRATE

(30) Priorité: 27.12.2016 FR 1663409
(43) Date de publication de la demande: 06.11.2019
(73) Titulaire: Aledia, 38040 Grenoble (FR)
(72) Inventeur: POURQUIER, Eric, 38000 Grenoble (FR)
(74) Mandataire: INNOV-GROUP
(86) Numéro de dépôt international: PCT/FR2017/053817
(87) Numéro de publication internationale: WO 2018/122517

(56) Documents cités:
- WO-A1-2011/048318
- JP-A- 2015 199 650
- US-A1- 2005 176 192
- US-A1- 2013 052 805
- US-A1- 2015 008 456
- US-A1- 2015 155 331

## Description

### DOMAINE TECHNIQUE

Le domaine de l'invention est celui des procédés de fabrication d'un dispositif optoélectronique à diodes électroluminescentes ou à photodiodes. L'invention s'applique en particulier au domaine des dispositifs à matrice de diodes électroluminescentes tels que les écrans d'affichage et les projecteurs d'image, ainsi qu'à celui des dispositifs à matrice de photodiodes tels que les photodétecteurs et les capteurs d'image.

### ÉTAT DE LA TECHNIQUE ANTÉRIEURE

Les procédés de fabrication de dispositifs optoélectroniques à diodes électroluminescentes peuvent comporter une étape de suppression, totale ou partielle, du substrat de croissance à partir duquel les diodes ont été formées. C'est notamment le cas lorsqu'on souhaite réaliser une pixellisation des diodes électroluminescentes pour fabriquer un écran d'affichage ou un projecteur d'image.

Les diodes électroluminescentes d'un tel dispositif optoélectronique peuvent comporter chacun un élément semiconducteur tridimensionnel, par exemple un fil, qui forme une première portion dopée dont une partie est recouverte par une zone active pouvant comporter au moins un puits quantique, et par une seconde portion dopée, les première et seconde portions dopées formant une jonction PN.

Le document WO2011/048318 décrit ainsi un exemple de procédé de fabrication d'un dispositif optoélectronique à diodes électroluminescentes filaires, dans le but d'obtenir un écran émissif. Ce procédé comprend notamment la fourniture d'un substrat de croissance, la formation d'une pluralité de diodes électroluminescentes à partir du substrat de croissance, puis la suppression ici totale du substrat de croissance après avoir assemblé l'extrémité libre des diodes électroluminescentes à une matrice active. La suppression du substrat de croissance peut être réalisée par gravure chimique ou par érosion.

Cependant, il apparaît que la suppression du substrat tel que décrit dans ce document est susceptible d'entraîner une dégradation structurelle d'au moins une partie du dispositif optoélectronique.

### EXPOSÉ DE L'INVENTION

L'invention a pour objectif de remédier au moins en partie aux inconvénients de l'art antérieur, et plus particulièrement de proposer un procédé de fabrication d'un dispositif optoélectronique, comportant les étapes suivantes :
a) fournir un substrat dit de croissance en un matériau semiconducteur, comportant une face avant et une face arrière opposées l'une à l'autre ;
b) former, sur la face avant, une pluralité de diodes, chaque diode comportant une face inférieure reposant sur le substrat ;
c) supprimer, à partir de la face arrière, au moins une portion du substrat de manière à rendre libre la face inférieure d'au moins une partie des diodes, la portion supprimée étant initialement située en regard de ladite partie de diodes ;
   dans lequel :
   - l'étape a) comporte la réalisation d'une partie inférieure et d'une partie supérieure du substrat s'étendant chacune en regard des diodes, lesdites parties étant dopées selon un même type de conductivité, la partie inférieure présentant un premier niveau de dopage, et la partie supérieure présentant un deuxième niveau de dopage inférieur au premier niveau et s'étendant à partir de la face avant jusqu'à la partie inférieure avec une épaisseur homogène ;
   - l'étape c) comportant une suppression de la partie inférieure par gravure chimique sélective vis-à-vis de la partie supérieure.

Certains aspects préférés mais non limitatifs de ce procédé de fabrication sont les suivants.

L'étape c) peut comporter en outre une suppression par gravure chimique de la partie supérieure du substrat, totale ou partielle dans un plan parallèle à la face avant, de manière à rendre libre la face inférieure des diodes.

Chaque diode peut comporter un élément semiconducteur qui participe à former une jonction PN de la diode, la face inférieure de chaque diode étant en contact électrique avec ledit élément semiconducteur. Le procédé de fabrication peut comporter une étape d) de formation d'au moins un premier plot conducteur au contact de la face inférieure de ladite partie des diodes.

Lors de l'étape b), les diodes peuvent être réparties spatialement en une pluralité d'ensembles distincts de diodes, chaque ensemble étant destiné à former un pixel du dispositif optoélectronique.

Lors de l'étape d), une pluralité de premiers plots conducteurs distincts peut être formée, chaque premier plot conducteur étant au contact de la face inférieure des diodes d'un même ensemble.

La partie supérieure peut comporter des portions dites centrales séparées les unes des autres, dans un plan parallèle à la face avant, par des portions dites latérales, chaque portion centrale étant située en regard d'un ensemble de diodes et les portions latérales étant situées entre les ensembles de diodes.

L'étape c) peut comporter une suppression partielle de la partie supérieure, dans un plan parallèle à la face avant, de manière à supprimer les portions centrales et à conserver les portions latérales, lesquelles forment ainsi des parois latérales de maintien.

Lors de l'étape c), les portions centrales peuvent être gravées par gravure humide ou sèche.

L'étape a) peut comporter la réalisation desdites portions centrales par dopage localisé de la partie supérieure de sorte que lesdites portions centrales présentent un niveau de dopage égal ou supérieur au premier niveau de dopage et que les portions latérales présentent le deuxième niveau de dopage, chaque portion centrale étant séparée des portions centrales adjacentes par l'une desdites portions latérales, et chaque portion centrale présentant une épaisseur strictement inférieure à l'épaisseur de la partie supérieure.

L'étape c) peut comporter, à la suite de la suppression de la partie inférieure, une phase d'amincissement du substrat de sorte que la face arrière débouche sur les portions centrales, puis la suppression des portions centrales par gravure chimique sélective vis-à-vis des portions latérales, de manière à rendre libre la face inférieure des ensembles de diodes, les portions latérales formant ainsi des parois latérales de maintien.

Ladite épaisseur de la partie supérieure peut être comprise entre 0,5µm et 20µm, de sorte que, à la suite de l'étape c), les parois latérales de maintien présentent une hauteur comprise entre 0,5µm et 20µm.

L'étape b) peut comporter l'épitaxie des éléments semiconducteurs à partir d'une couche de nucléation réalisée en un matériau électriquement isolant. L'étape c) peut comporter la suppression de portions de la couche de nucléation, de sorte qu'à la suite de l'étape d), les premiers plots conducteurs sont au contact d'une surface inférieure des éléments semiconducteurs formant la face inférieure des diodes.

L'étape b) peut comporter l'épitaxie des éléments semiconducteurs à partir d'une couche de nucléation réalisée en un matériau conducteur ou semiconducteur, les premiers plots conducteurs étant, à la suite de l'étape d), au contact d'une surface inférieure de la couche de nucléation formant la face inférieure des diodes.

L'étape b) peut comporter le dépôt d'une couche d'électrode conductrice et au moins partiellement transparente recouvrant toutes les diodes, et dans lequel un deuxième plot conducteur est en contact électrique avec la couche d'électrode.

Le deuxième plot conducteur peut être situé du côté d'une surface dite inférieure de la couche d'électrode orientée vers la face inférieure, ou peut être situé du côté d'une surface dite supérieure de la couche d'électrode opposée à la surface inférieure.

L'étape b) peut comporter le dépôt d'une couche diélectrique sur la face avant du substrat de croissance ou sur une couche de nucléation, un ou des premiers plots conducteurs étant au contact de la face inférieure des diodes, et étant électriquement isolés de la couche d'électrode par la couche diélectrique.

Chaque diode peut comporter un élément semiconducteur tridimensionnel.

Le matériau semiconducteur du substrat de croissance peut être du silicium dopé selon une conductivité de type P ou de type N.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A à 1C sont des vues en coupe, schématiques et partielles, d'un dispositif optoélectronique pour différentes étapes d'un procédé de fabrication conduisant à une dégradation structurelle d'au moins une partie du dispositif optoélectronique ;
les figures 2A à 2G sont des vues en coupe, schématiques et partielles, d'un dispositif optoélectronique pour différentes étapes d'un procédé de fabrication selon un premier mode de réalisation ;
les figures 3A et 3B sont des vues schématiques, respectivement en coupe et de dessus, d'une variante du dispositif optoélectronique illustré sur la fig.2G ; et la figure 3C est une vue schématique en coupe d'une variante du dispositif illustré sur la fig.3A ;
les figures 4A à 4C sont des vues en coupe, schématiques et partielles, d'un dispositif optoélectronique pour différentes étapes d'un procédé de fabrication selon un deuxième mode de réalisation ;
les figures 5A à 5G sont des vues en coupe, schématiques et partielles, d'un dispositif optoélectronique pour différentes étapes d'un procédé de fabrication selon un troisième mode de réalisation ;
les figures 6A et 6B sont des vues schématiques, en coupe, de variantes du dispositif optoélectronique illustré sur la fig.4C.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

L'invention porte sur un procédé de fabrication d'un dispositif optoélectronique 1 à diodes 20, qui comprend une étape de suppression d'au moins une portion du substrat 10, sur toute son épaisseur, sur laquelle reposaient initialement des diodes 20.

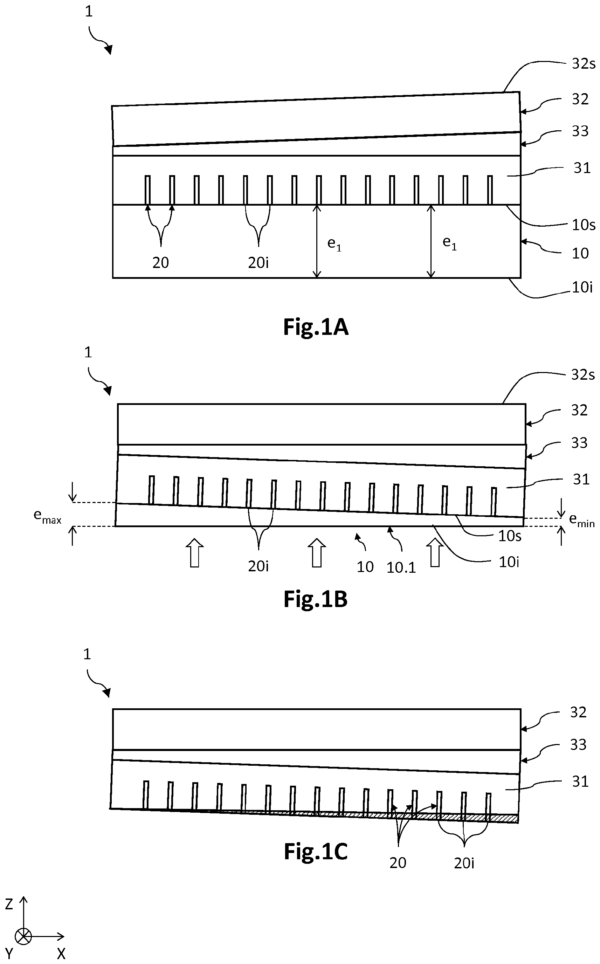

Comme l'illustrent les figures 1A à 1C, un procédé de fabrication d'un dispositif optoélectronique 1 peut conduire à des dégradations structurelles d'au moins une partie des diodes 20. Un tel procédé peut comporter :
- la formation d'une pluralité de diodes 20, les diodes 20 étant par exemple réalisées à base de nitrure de gallium (GaN), à partir d'une face avant 10s d'un substrat de croissance 10, celui-ci étant par exemple réalisé en silicium ;
- le dépôt d'une couche diélectrique 31 encapsulant toutes les diodes 20, puis la fixation d'une poignée de maintien 32 sur la couche d'encapsulation, ici par l'intermédiaire d'une couche de colle 33.
- la suppression d'au moins une portion du substrat 10 sur toute son épaisseur de manière à rendre libre une face inférieure 20i des diodes 20, la portion supprimée étant initialement située en regard d'au moins une partie des diodes 20 ;
- éventuellement, la formation d'au moins un plot conducteur (non représenté) sur la face inférieure 20i rendue libre des diodes 20.

En référence à la figure 1A, il apparaît que, à la suite de l'étape de fixation de la poignée 32, l'empilement formé du substrat de croissance 10, des diodes électroluminescentes 20 et de la poignée 32 collée ici à la couche d'encapsulation 31 par la couche 33 de colle, peut entraîner, au niveau de la face arrière 10i du substrat de croissance 10, des défauts de planéité issus notamment d'inégalités d'épaisseur dans le plan XY de chacune des couches de l'empilement. Dans cet exemple, le défaut de planéité se traduit par un défaut de parallélisme entre un plan passant par la face arrière 10i du substrat de croissance 10 et un plan passant par la face supérieure 32s de la poignée 32.

En référence à la figure 1B, l'étape de suppression de la portion du substrat de croissance 10 peut comporter une phase préalable d'amincissement du substrat de croissance 10 sur toute sa surface, par exemple par des techniques classiques de rodage, également appelées meulage, jusqu'à conserver une couche résiduelle 10.1 de faible épaisseur du substrat de croissance 10. La suppression du substrat 10 peut ensuite être réalisée par une gravure chimique de la couche résiduelle 10.1. Le meulage consiste généralement à fixer la poignée 32 à un porte-outil puis à appliquer un outil de meulage rotatif à la face arrière 10i du substrat 10, suivant les flèches représentées sur la fig.1B. Il apparaît que, à la suite de la phase de meulage, les défauts de planéité initiaux se traduisent par l'obtention d'une couche résiduelle 10.1 dont l'épaisseur présente des inhomogénéités Δe_{xy} dans le plan XY. Ainsi, la couche résiduelle 10.1 peut présenter une épaisseur qui varie localement entre une valeur maximale eₘₐₓ et une valeur minimale eₘᵢₙ.

En référence à la figure 1C, lors de la suppression de la couche résiduelle 10.1 par gravure chimique, une éventuelle sur-gravure des diodes électroluminescentes 20 peut avoir lieu dans la zone d'épaisseur eₘᵢₙ dans la mesure où le temps de gravure est essentiellement corrélé à l'épaisseur maximale eₘₐₓ de la couche résiduelle 10.1 à graver. Cette sur-gravure peut conduire à une dégradation structurelle locale du dispositif optoélectronique 1 (zone hachurée).

Dans l'exemple précédent, les défauts de planéité sont associés aux inhomogénéités d'épaisseur des différentes couches formant l'empilement. Cependant, les inhomogénéités d'épaisseur Δe_{xy}, de la couche résiduelle 10.1 peuvent être également dues à un défaut de parallélisme entre le porte-outil et l'outil de meulage lors de la phase de meulage. Par ailleurs, en variante ou en complément d'une phase de meulage, la phase d'amincissement peut comporter la mise en œuvre d'une gravure chimique du substrat de croissance 10 jusqu'à obtenir la couche résiduelle 10.1 à graver. L'amincissement du substrat 10 par gravure chimique est également susceptible d'entraîner des inhomogénéités d'épaisseur Δe_{xy}, de la couche résiduelle 10.1, pouvant conduire à la dégradation structurelle du dispositif optoélectronique 1.

Pour réduire les risques de dégradations structurelles du dispositif 1, le procédé de fabrication selon les modes de réalisation décrits par la suite prévoit de former un substrat de croissance 10 en un matériau semiconducteur dopé selon un premier type de conductivité, de type P ou de type N, le substrat 10 comportant une partie dite inférieure 11 présentant un premier niveau de dopage et une partie dite supérieure 12 présentant un deuxième niveau de dopage inférieur au premier niveau, située entre la partie inférieure 11 et la face avant 10s du substrat de croissance 10. Comme détaillé plus loin, dans la mesure où la partie supérieure 12 présente une épaisseur homogène e_{ref} à partir de la face avant 10s, et par une étape de gravure chimique sélective de la partie inférieure 11 vis-à-vis de la partie supérieure 12, le procédé permet d'obtenir une couche résiduelle 10.1 d'épaisseur constante dans le plan XY, ce qui permet ensuite de fabriquer un dispositif optoélectronique 1 sensiblement préservé des éventuelles dégradations mentionnées précédemment.

De préférence, le dispositif optoélectronique 1 comporte des diodes 20 réparties spatialement en une pluralité d'ensembles D distincts de diodes 20, les ensembles D étant adaptés à être polarisés de manière indépendante les uns des autres, formant ainsi des pixels Px distincts. Les diodes 20 peuvent être électroluminescentes et le dispositif optoélectronique 1 peut former un écran d'affichage ou un dispositif de projection d'image.

Les diodes 20 comportent des éléments semiconducteurs 21 qui participent à former une jonction PN des diodes. Autrement dit, chaque diode comporte une jonction semiconductrice formée de deux éléments semiconducteurs dopés selon des types de conductivité opposés. La jonction peut être de type PN ou de type PIN.

Selon un mode de réalisation, les diodes 20 comportent des éléments semiconducteurs tridimensionnels 21 qui peuvent présenter une forme allongée suivant un axe longitudinal, c'est-à-dire dont la dimension longitudinale suivant l'axe longitudinal est supérieure aux dimensions transversales. Les éléments tridimensionnels sont alors appelés « fils », « nanofils » ou « microfils ». Les dimensions transversales des fils 21, c'est-à-dire leurs dimensions dans un plan orthogonal à l'axe longitudinal, peuvent être comprises entre 10nm et 10µm, par exemple comprises entre 100nm et 10µm, et de préférence comprises entre 100 nm et 5µm. La hauteur des fils 21, c'est-à-dire leur dimension longitudinale suivant l'axe longitudinal, est supérieure aux dimensions transversales, par exemple 2 fois, 5 fois et de préférence au moins 10 fois supérieure.

La section droite des fils 21, dans un plan orthogonal à l'axe longitudinal, peut présenter différentes formes, par exemple une forme circulaire, ovale, polygonale par exemple triangulaire, carrée, rectangulaire voire hexagonale. On définit ici le diamètre comme étant une grandeur associée au périmètre du fil 21 au niveau d'une section droite. Il peut s'agir du diamètre d'un disque présentant la même surface que la section droite du fil 21. Le diamètre local est le diamètre du fil 21 à une hauteur donnée de celui-ci suivant l'axe longitudinal. Le diamètre moyen est la moyenne, par exemple arithmétique, des diamètres locaux le long du fil 21 ou d'une portion de celui-ci.

Dans la suite de la description, les diodes 20 sont des diodes électroluminescentes 20 réalisées en configuration dite cœur/coquille, dans le sens où le fil 21 est une première portion dopée, par exemple de type N, qui forme le cœur de la diode, lequel est entouré d'une coquille 22 formée d'une zone active et d'une seconde portion dopée P. Alternativement, les diodes électroluminescentes 20 peuvent être réalisées en configuration axiale dans laquelle la zone active et la seconde portion dopée sont situées essentiellement dans le prolongement du fil 21, suivant l'axe longitudinal, sans entourer ce dernier.

Les fils 21 peuvent être réalisés en un matériau cristallin épitaxié à partir d'une surface de nucléation, celle-ci pouvant être une surface d'un substrat de croissance 10 ou une surface d'une couche ou d'un plot de nucléation 23 réalisé en un matériau différent de celui du substrat de croissance 10. Le matériau des fils 21 comporte majoritairement un premier composé semiconducteur qui peut être choisi parmi les composés III-V et en particulier les composés III-N, parmi les composés II-VI ou parmi les composés ou éléments IV. A titre d'exemple, des composés III-V peuvent être des composés tels que GaN, InGaN, AlGaN, AlN, InN ou AlInGaN, voire des composés tels que l'AsGa ou l'InP. Des composés II-VI peuvent être CdTe, HgTe, CdHgTe, ZnO, ZnMgO, CdZnO, CdZnMgO. Des éléments ou composés IVpeuvent être Si, C, Ge, SiC, SiGe, GeC. Les fils 21 forment ainsi les premières portions des diodes 20, et sont dopés selon un type de conductivité, ici de type N. Dans cet exemple, les fils sont en GaN dopé de type N, notamment par du silicium. Ils présentent ici un diamètre moyen compris entre 10nm et 10µm, par exemple compris entre 100nm et 5µm et est ici sensiblement égal à 500nm. La hauteur des fils 21 peut être comprise entre 100nm et 100µm, par exemple comprise entre 500nm et 50µm, et est ici sensiblement égale à 5µm.

La zone active est la portion de la diode 20 au niveau de laquelle est émis l'essentiel du rayonnement lumineux de la diode 20. Elle peut comprendre au moins un puits quantique réalisé en un composé semiconducteur présentant une énergie de bande interdite inférieure à celles du fil et de la seconde portion dopée. Elle peut recouvrir, dans la configuration cœur/coquille, la bordure supérieure et la bordure latérale du fil 21. Elle peut comporter un unique puits quantique ou une pluralité de puits quantiques sous forme de couches ou de boîtes intercalées entre des couches barrières. De manière alternative, la zone active peut ne pas comporter de puits quantique. Elle peut alors présenter une énergie de bande interdite sensiblement égale à celle du fil et de la seconde portion dopée. Elle peut être réalisée en un composé semiconducteur non intentionnellement dopé.

La seconde portion dopée forme une couche qui, dans la configuration cœur/coquille, recouvre et entoure au moins en partie la zone active. Elle est réalisée en un second composé semiconducteur dopé selon un type de conductivité opposé à celui du fil, c'est-à-dire ici de type P. Le second composé semiconducteur peut être identique au premier composé semiconducteur du fil 21 ou peut comporter le premier composé semiconducteur et en outre un ou plusieurs éléments supplémentaires d'alliage. Dans cet exemple, la seconde portion dopée peut être du GaN ou de l'InGaN, dopé de type P notamment par du magnésium. L'épaisseur de la seconde portion dopée peut être comprise entre 20nm et 500nm, et peut être égale à 150nm environ. Bien entendu, les types de conductivité des première et seconde portions peuvent être inversés.

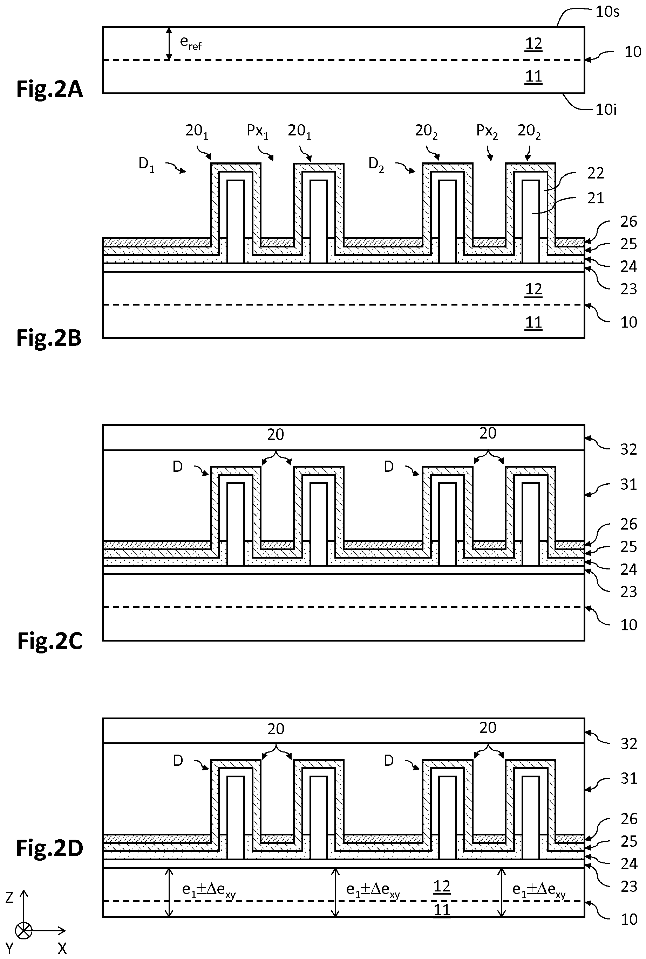

Les figures 2A à 2G illustrent des étapes d'un procédé de fabrication d'un dispositif optoélectronique 1 selon un premier mode de réalisation, le dispositif optoélectronique 1 comportant avantageusement des ensembles D distincts de diodes 20, ici électroluminescentes, réalisées par épitaxie à partir d'un substrat de croissance 10, le procédé comportant une étape de suppression d'au moins des portions du substrat de croissance 10. Le dispositif optoélectronique 1 forme ici un écran d'affichage ou un dispositif de projection d'image.

On définit ici et pour la suite de la description un repère direct tridimensionnel (X,Y,Z), où les axes X et Y forment un plan parallèle au plan principal suivant lequel s'étendent les ensembles D de diodes électroluminescentes 20, et où l'axe Z est orienté de manière sensiblement orthogonale au plan principal. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan XY. Par ailleurs, les termes « inférieur » et « supérieur » s'entendent comme étant relatifs à un positionnement croissant suivant la direction +Z.

La figure 2A illustre une étape de fourniture d'un substrat de croissance 10 à partir duquel sont réalisées les diodes électroluminescentes 20. Le substrat de croissance 10 est réalisé en un matériau semiconducteur monolithique, de préférence cristallin et avantageusement monocristallin. De préférence, le matériau semiconducteur est du silicium présentant un premier type de conductivité, ici de type P, mais l'invention s'applique également au silicium dopé de type N. Le substrat de croissance 10 présente une face avant 10s et une face arrière 10i opposées l'une à l'autre. La face avant 10s est la face du substrat 10 à partir de laquelle les diodes électroluminescentes 20 sont réalisées. Le substrat de croissance 10 peut présenter une épaisseur initiale, c'est-à-dire avant amincissement et suppression de portions, comprise par exemple entre 200µm et 1500µm, de préférence 725µm.

On réalise tout d'abord une partie dite inférieure 11 présentant un premier niveau de dopage, de préférence homogène, c'est-à-dire sensiblement constant suivant l'axe Z et dans le plan XY. De préférence, le premier niveau de dopage est tel que la résistivité électrique de la partie inférieure 11 est comprise entre 1 mΩ.cm et 50 mΩ.cm. Des exemples d'éléments dopants sont le bore (B) et l'aluminium (Al). La partie inférieure 11 s'étend continûment dans le plan XY, et est destinée à être en regard de chaque ensemble D de diodes 20. Dans cet exemple, la partie inférieure 11 est dite dopée P+. Par en regard, on entend d'une manière générale que la partie inférieure est située au droit, c'est-à-dire à la perpendiculaire, de l'ensemble de diodes.

On réalise ensuite une partie dite supérieure 12 présentant un deuxième niveau de dopage inférieur au premier niveau de dopage, de préférence homogène. De préférence, le deuxième niveau de dopage est tel que la résistivité électrique de la partie supérieure 12 est comprise entre 1Ω.cm et 100 Q.cm. La partie supérieure 12 s'étend également continûment dans le plan XY, et est destinée à être en regard de chaque ensemble D de diodes 20. Elle est située entre la partie inférieure 11 et la face avant 10s, et affleure, c'est-à-dire débouche, sur la face avant 10s. Elle présente une épaisseur e_{ref} homogène, c'est-à-dire que l'épaisseur de la partie supérieure 12 mesurée à partir de la face avant 10s du substrat 10, est constante dans le plan XY. A titre illustratif, l'épaisseur peut être comprise entre 0,5µm et 20µm environ. Dans cet exemple, la partie supérieure 12 est dite dopée P-. Elle peut être réalisée par épitaxie à partir de la partie inférieure 11 dopée P+.

La figure 2B illustre la formation, sur la face avant 10s du substrat de croissance 10, d'une pluralité d'ensembles D distincts de diodes 20, chaque diode 20 comportant un élément semiconducteur tridimensionnel 21 appelé par la suite fil. Chaque ensemble D de diodes 20 s'étend dans le plan XY sur une zone destinée à former un pixel Px qui peut être activé indépendamment des autres pixels. Sont représentés ici un premier ensemble D₁ de premières diodes 20₁ et un deuxième ensemble D₂ de deuxièmes diodes 20₂. Les ensembles D de diodes 20 sont situés en regard de la partie supérieure 12 dopée P- du substrat de croissance 10, dans le sens où chaque ensemble D est située à la perpendiculaire de la partie supérieure 12 dopée P-.

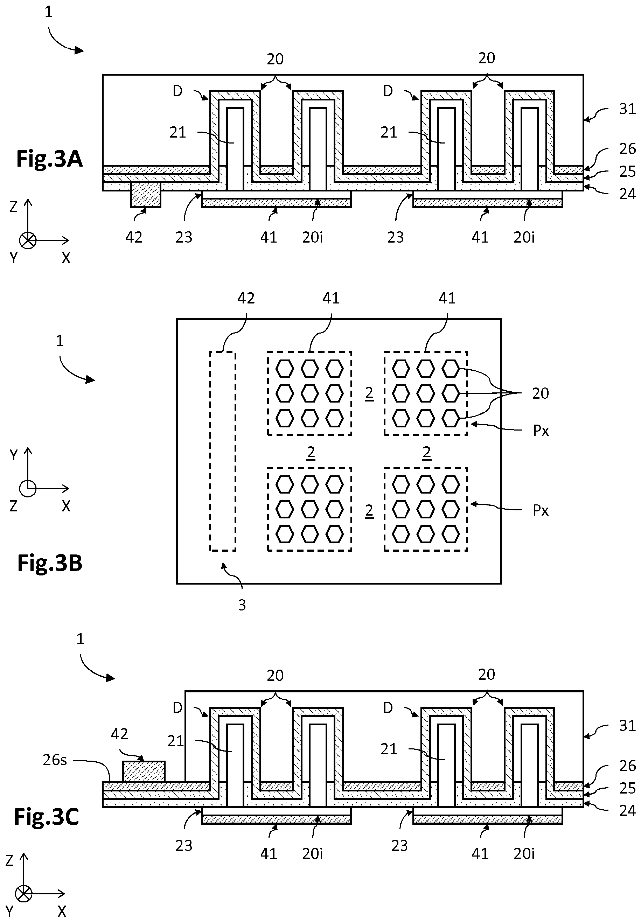

On dépose une couche de nucléation 23 sur et au contact de la face avant 10s du substrat de croissance 10, et en particulier au niveau des zones P de la face avant 10s destinée à former les pixels lumineux. Cette étape, bien que facultative, est avantageuse dans la mesure où la couche 23 favorise la nucléation des fils 21. La couche de nucléation 23 peut être réalisée en nitrure d'aluminium (AlN), en oxyde d'aluminium (par exemple Al₂O₃), en nitrure de magnésium (MgₓN_{y}), en nitrure ou en carbure d'un métal de transition ou en tout autre matériau adapté. L'épaisseur de la couche de nucléation 23 peut être de l'ordre de quelques nanomètres à quelques dizaines ou centaines de nanomètres. Dans cet exemple, la couche de nucléation 23 est en un matériau électriquement isolant, par exemple en AlN. En variante, comme décrit plus loin en référence à la fig.3A, le matériau peut être électriquement conducteur. La couche de nucléation 23 peut se présenter sous la forme d'une couche continue qui recouvre la face avant 10s, ou sous la forme d'une pluralité de plots de nucléation distincts les uns des autres, obtenus par exemple par des étapes classiques de photolithographie et de gravure de la couche de nucléation 23.

On dépose ensuite, sur la couche de nucléation 23, une couche diélectrique 24 formant un masque de croissance autorisant la croissance épitaxiale localisée des fils 21 à partir d'ouvertures débouchant localement sur la couche de nucléation 23. La couche diélectrique 24 est réalisée en un matériau électriquement isolant tel que, par exemple, un oxyde de silicium (par exemple SiO₂) ou un nitrure de silicium (par exemple Si₃N₄), voire un oxynitrure de silicium. L'épaisseur de la couche diélectrique 24 peut être comprise entre 5nm et 800nm, par exemple égale à 30nm environ.

On réalise ensuite les diodes électroluminescentes 20 qui comportent chacune un élément semiconducteur tridimensionnel 21 par croissance épitaxiale à partir de la couche de nucléation 23, par exemple par croissance épitaxiale en phase vapeur aux organométalliques (MOCVD, pour *Metal Organic Chemical Vapor Deposition,* en anglais). Les éléments tridimensionnels 21 sont ici des fils, également appelés premières portions dopées, qui s'étend à partir de la couche de nucléation 23 de manière sensiblement perpendiculaire à l'axe Z. Chaque diode 20 comporte en outre une coquille 22 comportant une zone active et une seconde portion dopée, ainsi qu'une couche conductrice d'électrode 25, en contact avec la seconde portion dopée de la coquille 22. Les fils 21, et d'une manière générale les diodes électroluminescentes 20, peuvent être formés selon un procédé identique ou similaire à celui décrit dans la demande WO2012/136665 qui est considérée comme faisant partie intégrante de la présente description. Ainsi, on réalise les fils 21 par croissance épitaxiale, et les coquilles 22 formées chacune de la zone active et la seconde portion dopée.

La seconde portion dopée peut comporter en outre une couche intercalaire de blocage d'électrons (non représentée) située à l'interface avec la zone active. La couche de blocage d'électrons peut ici être formée d'un composé ternaire III-N, par exemple de l'AlGaN ou de l'AlInN, avantageusement dopé p. Elle permet d'accroître le taux de recombinaisons radiatives dans la zone active.

On dépose ensuite une couche conductrice 25 dite d'électrode, qui recouvre ici toutes les diodes électroluminescentes 20 des différents ensembles D. La couche d'électrode 25 est adaptée à appliquer une même valeur de polarisation électrique aux diodes 20 par l'intermédiaire d'un deuxième plot conducteur décrit plus loin. Elle est réalisée en un matériau au moins partiellement transparent au rayonnement lumineux émis par les diodes 20, par exemple en oxyde d'indium étain (ITO, pour Indium Tin Oxide en anglais) ou en ZnO éventuellement dopé (par exemple au gallium ou à l'aluminium). Elle peut présenter une épaisseur de l'ordre de quelques nanomètres à quelques dizaines ou centaines de nanomètres, par exemple comprise entre 5nm et 500nm, de préférence comprise entre 10nm et 100nm, par exemple égale à 50nm environ.

On dépose ensuite une couche conductrice 26, dite supérieure, sur la couche conductrice 25 d'électrode de manière à ne pas recouvrir la surface émissive formée par la coquille 22 des diodes 20. Elle est réalisée en un ou plusieurs matériaux conducteurs choisis parmi l'aluminium, l'argent, l'or, le cuivre, ruthénium ou tout autre matériau adapté, et présente une épaisseur par exemple comprise entre 20nm et 1500nm, de préférence comprise entre 400nm et 800nm. La couche conductrice 26 permet de réduire la résistance électrique et améliore ainsi la circulation du courant électrique dans la couche d'électrode 25.

La figure 2C illustre une étape de dépôt d'une couche d'encapsulation 31 puis une étape de fixation d'une poignée 32, ici par l'intermédiaire d'une couche de colle (non représentée). La couche d'encapsulation 31 recouvre toutes les diodes 20 et en particulier la couche d'électrode 25. Elle présence ainsi une épaisseur comprise entre 250nm et 50µm. Elle est réalisée en un matériau électriquement isolant et au moins partiellement transparent au rayonnement émis par les diodes 20, par exemple en un oxyde de silicium (par ex. SiO₂) ou d'aluminium (par ex. Al₂O₃), un nitrure de silicium ou d'aluminium ou autre matériau inorganique adapté, ou encore un polymère de type silicone, époxyde, acrylique ou autre matériau organique adapté. La couche d'encapsulation 31 peut comporter des luminophores adaptés à convertir au moins une partie du rayonnement lumineux émis par les diodes 20 en un rayonnement lumineux d'une autre longueur d'onde.

La poignée 32 peut être temporaire ou définitive. Elle peut être réalisée en un matériau au moins partiellement transparent au rayonnement émis par les diodes 20, par exemple en verre, ou en verre borosilicate voire en pyrex, ou en saphir. La fixation de la poignée 32 à la couche d'encapsulation 31 peut être réalisée par collage, par exemple à l'aide d'une colle pouvant être réticulée en température ou aux rayonnements ultraviolets, voire par collage moléculaire.

La figure 2D illustre une phase d'amincissement du substrat de croissance 10 à partir de la face arrière 10i, de manière à diminuer l'épaisseur de la partie inférieure 11 dopée P+. L'épaisseur locale de la partie inférieure 11 dopée P+ après amincissement reste non nulle, de sorte que la partie supérieure 12 dopée P- garde son épaisseur e_{ref} constante. L'amincissement peut être réalisé par une technique de gravure chimique, humide ou sèche, ou par une technique de meulage. Comme mentionné précédemment, le substrat de croissance 10 aminci peut présenter des inhomogénéités d'épaisseur Δe_{xy}, dans le plan XY, du fait par exemple d'un défaut initial de parallélisme de l'empilement formé du substrat de croissance 10, de la pluralité des diodes 20 encapsulée et de la poignée 32, et/ou du fait de la technique d'amincissement mécanique ou chimique utilisée. Aussi, le substrat 10 aminci présente une épaisseur e₁ qui peut varier localement entre une valeur maximale eₘₐₓ et une valeur minimale eₘᵢₙ.

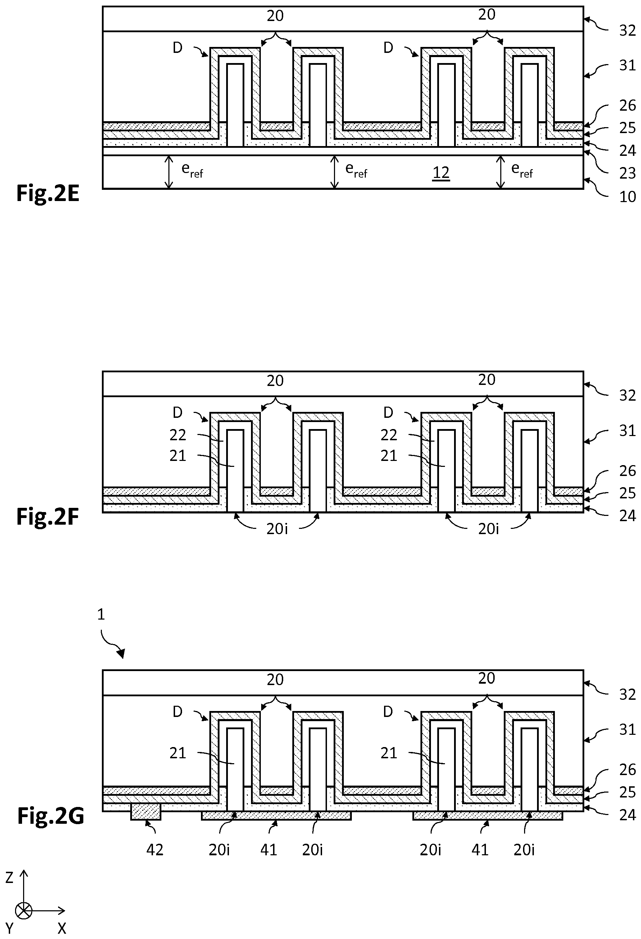

La figure 2E illustre la suppression de la partie inférieure 11 dopée P+ par gravure chimique sélective vis-à-vis de la partie supérieure 12 dopée P-. L'attaque chimique peut être humide ou sèche, et est ici effectuée en milieu humide en utilisant un agent de gravure choisi parmi un ou plusieurs acides forts ou acides faibles, par exemple, entre autres, l'acide fluorhydrique (HF), l'acide nitrique (HNO₃) ou l'acide acétique (CH₃-CO-OH). En effet, un tel agent de gravure présente un fort écart de vitesse de gravure entre la partie inférieure 11 en silicium fortement dopé et la partie supérieure 12 en silicium faiblement dopé. Ainsi, la partie inférieure 11 dopée P+ est gravée au moins 50 fois voire 100 fois plus vite que la partie supérieure 12 dopée P-, ce qui se traduit par une certaine sélectivité de gravure entre les parties 11, 12. A la suite de l'étape de suppression de la partie inférieure 11 dopée P+, le substrat 10 aminci ne comporte que la partie supérieure 12 dopée P-, dont l'épaisseur e_{ref} est constante dans le plan XY. Ainsi, les inhomogénéités d'épaisseur du substrat de croissance 10, liée au défaut initial de planéité et/ou à l'étape d'amincissement mécanique ou chimique, ont été sensiblement supprimées.

La figure 2F illustre la suppression de la partie supérieure 12 dopée P- par une gravure chimique, humide ou sèche, sélective vis-à-vis, dans cet exemple, de la couche de nucléation 23. La gravure chimique est ici humide et l'agent de gravure peut être choisi parmi des acides ou des bases, celles-ci pouvant être, par exemple, de l'hydroxyde de tétraméthylammonium (TMAH) ou de l'hydroxyde de potassium (KOH). La partie supérieure 12 dopée P- est, dans cet exemple, supprimée totalement. Ainsi, la surface inférieure de la couche de nucléation 23 est rendue libre, c'est-à-dire qu'elle n'est pas revêtue d'un matériau, et plus précisément n'est plus au contact du matériau du substrat de croissance 10.

Dans cet exemple, le matériau de la couche de nucléation 23 est électriquement isolant. Aussi, on procède également à la suppression de la couche de nucléation 23, soit totale dans le plan XY, soit partielle de manière localisée dans le plan XY, par exemple dans les zones des ensembles D de diodes 20. Dans cet exemple, la couche de nucléation 23 est totalement supprimée, ici par une gravure chimique, humide ou sèche, sélective vis-à-vis du matériau du fil 21 et du matériau de la couche diélectrique 24. On rend ainsi libre la face inférieure 20i des diodes 20, celle-ci étant ici formée par la surface inférieure des fils 21. La face inférieure d'une diode 20 est la face de la diode 20 vis-à-vis de laquelle le fil 21 est en contact électrique. Elle peut correspondre à la surface inférieure du fil 21 ou d'une surface inférieure d'une couche de nucléation en un matériau conducteur ou semiconducteur à partir de laquelle le fil a été épitaxié.

La figure 2G illustre la formation d'une pluralité de premiers plots conducteurs 41, chaque plot conducteur 41 étant déposé en regard d'un ensemble D distinct de diodes 20, et au contact de la face inférieure 20i des diodes 20 de l'ensemble D considéré. Chaque plot conducteur 41 est réalisé en un ou plusieurs matériaux conducteurs choisis de manière à assurer un contact ohmique avec la face inférieure 20s des diodes 20, par exemple un empilement du type Ti/Al/Ni/Au dans le cas de fils en GaN, ou tout autre matériau adapté, et présente une épaisseur par exemple comprise entre 1µm et 10µm, par exemple 5µm environ. Un deuxième plot conducteur 42 est situé en bordure des ensembles D de diodes 20, et est au contact de la couche d'électrode 25 au travers d'une ouverture traversante pratiquée dans la couche diélectrique 24.

Ainsi, on obtient un dispositif optoélectronique 1 dont la structure a été préservée lors du procédé de fabrication par le fait que les éventuelles inhomogénéités d'épaisseur Δe_{xy}, introduites dans le substrat de croissance 10 ont été supprimées lors de la gravure chimique sélective de la partie inférieure 11 dopée P+, permettant d'obtenir une couche résiduelle de croissance d'épaisseur e_{ref} constante formée par la partie supérieure 12 dopée P-.

Par ailleurs, le dispositif optoélectronique 1 présente ici une résistance thermique diminuée dans la mesure où le substrat de croissance 10 a été supprimé totalement, ce qui améliore l'évacuation de la chaleur produite par le dispositif 1 en fonctionnement. De plus, dans cet exemple, le dispositif optoélectronique 1 présente un maintien mécanique assuré essentiellement par l'épaisseur de la couche d'encapsulation 31 associée à l'épaisseur de la poignée transparente 32. En variante, la poignée peut être temporaire et peut être supprimée à une étape ultérieure du procédé de fabrication. La tenue mécanique du dispositif optoélectronique 1 peut alors être assurée essentiellement par l'épaisseur de la couche d'encapsulation 31 et de préférence par une puce de commande hybridée au dispositif optoélectronique.

L'agencement des différents plots conducteurs 41, 42 permet de fixer le dispositif optoélectronique 1 à une puce de commande (non représentée) adaptée à polariser les différents ensembles D de diodes 20 indépendamment les uns des autres. La fixation entre les plots conducteurs 41, 42 et la puce de commande peut être effectuée au moyen de billes en un matériau fusible, par exemple en indium, en SnAg, par des plots de cuivre ou d'or, voire par collage moléculaire de type cuivre/cuivre, ou par tout autre technique d'hybridation.

La figure 3A illustre une variante du dispositif optoélectronique 1 illustré sur la fig.2G, qui s'en distingue essentiellement en ce que la poignée 32 a été supprimée et en ce qu'une portion de nucléation 23, issue de la couche de nucléation, est conservée au niveau de chaque ensemble D de diodes 20, le matériau de nucléation étant alors conducteur ou semiconducteur. Dans cette variante, le matériau de nucléation est à la fois adapté à favoriser la nucléation des fils 21 et à permettre l'injection des porteurs de charge dans les fils 21. Le matériau de nucléation peut comporter un métal de transition. Il peut être choisi parmi le titane, le vanadium, le chrome, le zirconium, le niobium, le molybdène, le hafnium, le tantale et le tungstène, ou en un nitrure ou un carbure de métal de transition, par exemple de titane, de zirconium, de hafnium, de vanadium, de niobium, de tantale, de chrome, de molybdène, de tantale, ou en une combinaison de ces composés. Les métaux de transition, ainsi que leurs nitrures et carbures, présentent les avantages de permettre la nucléation des fils et d'avoir une conductivité électrique proche de celle des métaux.

De préférence, chaque portion de nucléation 23 peut présenter une structure similaire ou identique à celle décrite dans la demande FR16/56008 déposée le 28/06/2016 qui est considérée comme faisant partie intégrante de la présente description. Ainsi, la portion de nucléation 23 peut comporter une sous-couche supérieure en un matériau comportant un métal de transition épitaxié à partir d'une sous-couche inférieure en un matériau cristallin, celui-ci étant été épitaxié à partir, par exemple, de la surface du substrat de croissance 10.

La figure 3B est une vue de dessus du dispositif optoélectronique 1 illustré sur la fig.2G ou sur la fig.3A. Chaque ensemble D de diodes 20 forme un pixel Px du dispositif optoélectronique 1. Les ensembles D de diodes 20 sont séparés les uns des autres dans le plan XYpar une bordure intercalaire 2 non contactée électriquement à l'un ou l'autre des premiers plots conducteurs 41 (en trait pointillé). Le dispositif optoélectronique 1 comporte une bordure latérale 3 vis-à-vis des ensembles D de diodes 20, au niveau de laquelle est situé le deuxième plot conducteur 42.

La figure 3C illustre une variante du dispositif optoélectronique 1 illustré sur la fig.3A, qui s'en distingue essentiellement en ce que le deuxième plot conducteur 42 repose sur la face supérieure 26s de la couche conductrice 26, et est ainsi en contact électrique avec la couche d'électrode 25. En variante, la couche conductrice 26 peut ne pas s'étendre sur la couche d'électrode 25 dans cette zone, de sorte que le deuxième plot conducteur 42 est directement au contact de la couche d'électrode 25.

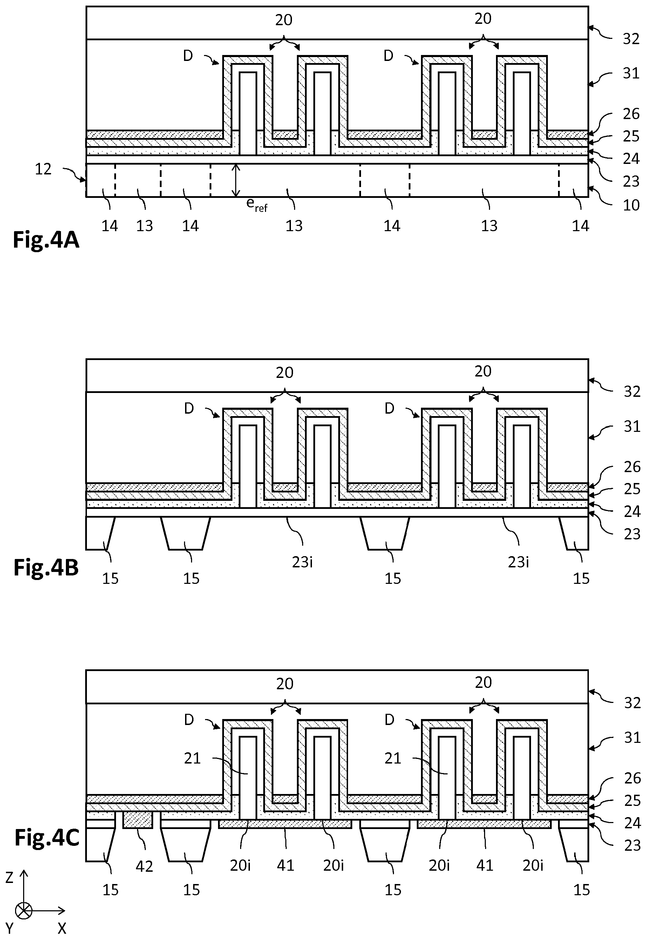

Les figures 4A à 4C illustrent certaines étapes d'un procédé de fabrication d'un dispositif optoélectronique 1 selon un deuxième mode de réalisation. Ce procédé de fabrication se distingue de celui décrit en référence aux fig.2A à 2G essentiellement en ce qu'il comporte la formation de parois latérales 15 de maintien par gravure localisée de portions de la partie supérieure 12 dopée P- du substrat de croissance 10. Les parois latérales 15 de maintien permettent notamment de renforcer la tenue mécanique du dispositif optoélectronique 1, tout en permettant la pixellisation des diodes 20, et peuvent également comporter des fonctions électroniques.

Les étapes initiales du procédé selon ce mode de réalisation sont identiques à celles décrites en référence aux fig.2A à 2E et ne sont pas décrites à nouveau.

La figure 4A illustre le dispositif optoélectronique 1 obtenu à la suite de l'étape de suppression de la partie inférieure 11 dopée P+ par gravure chimique sélective vis-à-vis de la partie supérieure 12 dopée P-, comme mentionné précédemment en référence à la fig.2E. Ainsi, les éventuelles inhomogénéités d'épaisseur Δe_{xy} du substrat de croissance 10 à la suite de la phase préalable d'amincissement sont supprimées, ce qui permet de réduire les risques de dégradations structurelles du dispositif optoélectronique 1.

La figure 4B illustre une étape de formation de parois latérales 15 de maintien, par gravure chimique localisée de portions dites centrales 13 de la partie supérieure 12 dopée P-, de manière à conserver des portions dites latérales 14 formant ensuite les parois latérales 15 de maintien.

Chaque portion centrale 13 supprimée est initialement située en regard d'un ensemble D de diodes 20, c'est-à-dire que chaque diode 20 de l'ensemble D considéré est située à la perpendiculaire d'une portion centrale 13. Les portions centrales 13 sont distinctes les unes des autres et sont séparées deux à deux par une portion latérale 14. Aussi, on comprend que les portions latérales 14 sont situées entre deux ensembles D de diodes 20 voisins, c'est-à-dire situées au regard de la bordure intercalaire 2 délimitant deux ensembles D adjacents.

La suppression des portions centrales 13 est effectuée par des étapes classiques de photolithographie et de gravure chimique des zones formant les portions centrales 13. Ces dernières présentent un niveau de dopage identique à celui de la partie supérieure 12 dopée P-. Elles sont gravées par une gravure humide, par exemple en milieu basique (par ex. KOH ou TMAH), ou par gravure sèche plasma (RIE, ICP...) sélective vis-à-vis de la couche de nucléation 23 le cas échéant (comme illustré sur la fig.4B), ou vis-à-vis des fils 21 et de la couche diélectrique 24.

Les portions latérales 14 non gravées forment alors des parois latérales 15 de maintien, dont la hauteur moyenne est sensiblement égale à l'épaisseur initiale e_{ref} des portions latérales 14 dopées P-. Ainsi, l'épaisseur de portions latérales 14 étant de préférence comprise entre 0,5µm et 20µm, les parois latérales 15 de maintien présentent une hauteur sensiblement égale à cette épaisseur initiale. Les parois latérales 15 forment de préférence un quadrillage continu qui entoure chaque ensemble D de diodes 20, par exemple en forme de nid d'abeille, où chaque ouverture traversante du quadrillage correspond à un pixel Px du dispositif optoélectronique 1.

Dans cet exemple, la couche de nucléation 23 étant réalisée en un matériau électriquement isolant, une gravure localisée de la couche de nucléation 23 est effectuée pour rendre libre la face inférieure 20i des diodes 20 vis-à-vis de laquelle les fils 21 sont en contact électrique.

La figure 4C illustre la formation des premiers plots conducteurs 41, chaque premier plot conducteur 41 étant au déposé en regard d'un ensemble D distinct de diodes 20. Les premiers plots conducteurs 41 sont séparés deux à deux, dans le plan XY, par une paroi latérale 15 de maintien. On prévoit dans cet exemple la formation d'un deuxième plot conducteur 42, situé sur une bordure latérale 3 du dispositif optoélectronique 1, qui est en contact avec la couche d'électrode 25 au travers d'une ouverture traversante pratiquée dans la couche diélectrique 24.

Les parois latérales 15 de maintien peuvent être fonctionnalisées et ainsi comporter des circuits électroniques actifs ou passifs, reliés à tout ou partie des ensembles D de diodes 20. Les circuits électroniques peuvent ainsi former une protection ESD, par exemple en comportant des diodes Zener, voire présenter des fonctions électroniques de contrôle ou commande du circuit électrique de polarisation des ensembles D de diodes. Outre les diodes Zener, des diodes Schottky ou des transistors de type MOS peuvent notamment être situés dans les parois latérales 15 de maintien.

Ainsi, ce procédé selon ce deuxième mode de réalisation permet de limiter la dégradation structurelle du dispositif optoélectronique 1 en écartant les inhomogénéités d'épaisseur Δe_{xy}, introduites dans le substrat de croissance 10 du fait des défauts initiaux de planéité voire par les techniques utilisées d'amincissement. On obtient ainsi une couche résiduelle d'épaisseur e_{ref} constante formée par la partie supérieure 12. Il permet en outre de réaliser les parois latérales 15 de maintien qui permettent de renforcer la tenue mécanique du dispositif optoélectronique 1. De plus, le fait que les parois latérales présentent une hauteur moyenne sensiblement identique d'une paroi latérale 15 à l'autre, la répartition spatiale des contraintes mécaniques est elle-même sensiblement homogène au sein du dispositif optoélectronique 1, ce qui permet de limiter les zones de concentration des contraintes et ainsi améliore à nouveau la tenue mécanique du dispositif optoélectronique. De plus, ce procédé permet d'obtenir un quadrillage continu dont les ouvertures traversantes, délimitées par les parois latérales de maintien, sont situées au niveau des ensembles D de diodes 20, ce qui autorise la pixellisation des diodes 20 par la formation des premiers plots conducteurs 41 au travers des ouvertures traversantes.

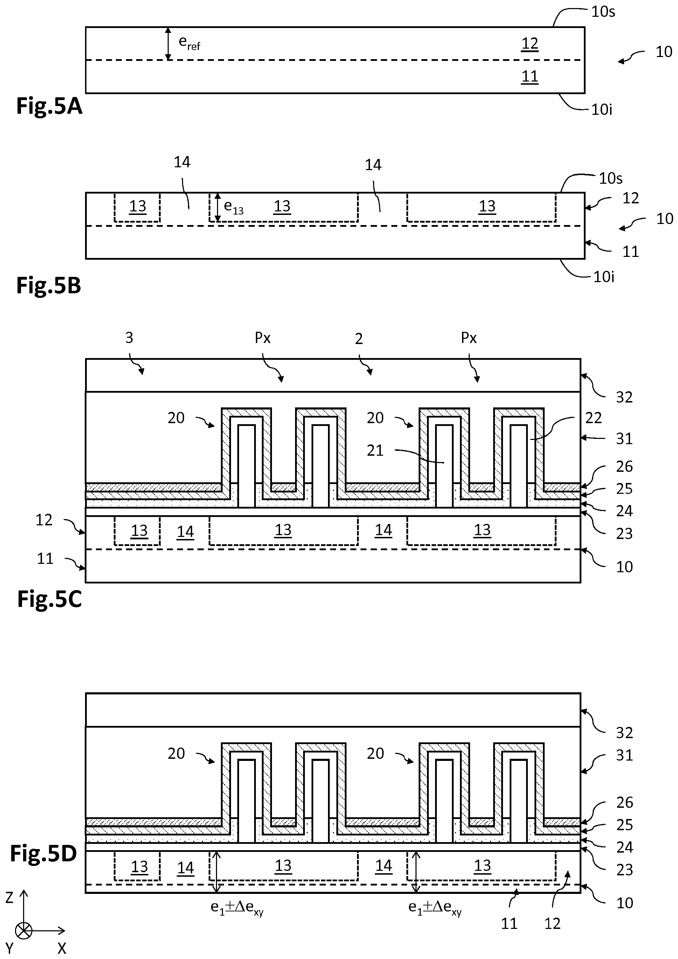

Les figures 5A à 5F illustrent des étapes d'un procédé de fabrication d'un dispositif optoélectronique 1 selon un troisième mode de réalisation. Ce procédé de fabrication se distingue de celui décrit en référence aux fig.4A à 4C essentiellement en ce que les portions centrales 13 sont préalablement formées lors de l'étape de fourniture du substrat de croissance 10, par dopage localisé de la partie supérieure 12 dopée P- de manière à obtenir des caissons 13 dopés P+ situés dans la partie supérieure 12 dopée P-.

Les figures 5A et 5B illustrent la fourniture d'un substrat de croissance 10 en un matériau semiconducteur, de préférence du silicium cristallin, dopé selon un même type de conductivité, ici de type P. En référence à la figure 5A, on forme dans le substrat 10 une partie inférieure 11 dite dopée P+ et une partie supérieure 12 dite dopée P-. Cette étape est similaire ou identique aux étapes décrites en référence à la fig.2A et n'est pas décrite à nouveau. La partie supérieure 12 dopée P- présente une épaisseur e_{ref} constante dans le plan XY.

En référence à la figure 5B, on réalise ensuite des portions dites centrales 13 et des portions dites latérales 14 dans la partie supérieure 12 dopée P-. Les portions centrales 13 sont réalisées par dopage localisé de la partie supérieure 12 dopée P-, c'est-à-dire par insertion localisée d'un dopant dans la partie supérieure 12, par implantation ionique ou par diffusion thermique, de manière à obtenir des portions 13 distinctes, dopées suivant le premier type de conductivité, ici de type P, avec un niveau de dopage sensiblement égal, voire supérieur, au premier niveau de dopage. Ainsi, les portions centrales 13 sont dites dopées de type P+, tout comme la partie inférieure 11. L'épaisseur e₁₃ des portions centrales 13 dopées P+ est ici strictement inférieure à l'épaisseur e_{ref} de la partie inférieure P-, de sorte que chaque portion centrale P+ est distincte de la partie inférieure 11 dopée P+ par une discontinuité spatiale du niveau de dopage suivant l'axe Z.

Les portions latérales 14 correspondent à des zones de la partie supérieure 12 dopée P- dont le niveau de dopage n'a pas été modifié. Elles présentent donc un niveau de dopage égal au deuxième niveau de dopage et sont dites dopées de type P-. L'épaisseur des portions latérales est sensiblement constante et est égale à l'épaisseur e_{ref} de la partie supérieure. Les portions latérales 14 sont en contact les unes avec les autres de manière à former une continuité spatiale du niveau de dopage, dans le plan XY, qui entoure chaque portion centrale 13.

La figure 5C illustre la formation, sur la face avant 10s du substrat de croissance 10 d'une pluralité d'ensembles D distincts de diodes 20. Cette étape est similaire ou identique à celle décrite en référence à la fig.2B et n'est pas détaillée à nouveau. Chaque ensemble D de diodes 20 est en regard d'une portion centrale 13 dopée P+, les portions latérales 14 dopées P- étant situées en regard d'une bordure intercalaire 2 séparant deux ensembles D adjacents.

On réalise ensuite le dépôt de la couche encapsulant 31 toutes les diodes 20 puis la fixation d'une poignée 32. Cette étape est similaire ou identique à celle décrite en référence à la fig.2C et n'est pas détaillée à nouveau.

La figure 5D illustre ensuite une première phase d'amincissement du substrat de croissance 10 à partir de la face arrière 10i, par gravure chimique humide ou sèche, ou par meulage, de manière à diminuer l'épaisseur de la partie inférieure 11 dopée P+. Comme décrit précédemment en référence à la figure 2D, la partie inférieure 11 dopée P+ n'est pas supprimée sur toute son épaisseur, de sorte que le substrat 10 aminci présente une épaisseur non nulle e₁ dans le plan XY, supérieure à l'épaisseur e_{ref} de la partie supérieure 12 dopée P-. Cependant, le substrat 10 aminci est maintenant susceptible de présenter des inhomogénéités d'épaisseur Δe_{xy}, du fait d'un défaut initial de parallélisme voire du fait de la technique d'amincissement mécanique ou chimique utilisée. Le substrat 10 aminci présente ainsi une épaisseur e₁ qui peut varier localement entre une valeur maximale eₘₐₓ et une valeur minimale eₘᵢₙ.

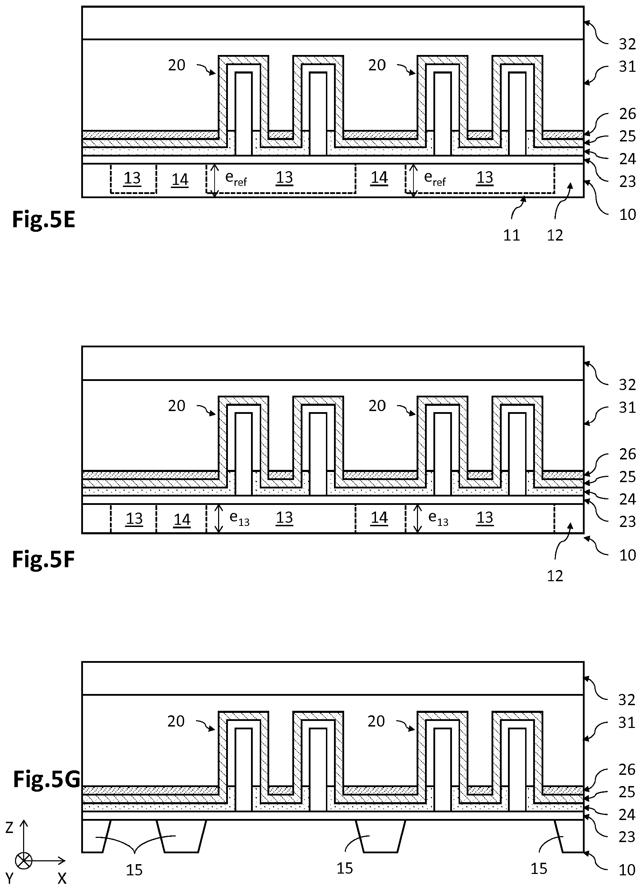

La figure 5E illustre la suppression de la partie inférieure 11 dopée P+ par gravure chimique sélective vis-à-vis des portions latérales dopées P-. Comme décrit précédemment, l'attaque chimique peut être humide ou sèche, et est ici effectuée en milieu humide en utilisant un agent de gravure choisi parmi un ou plusieurs acides forts et/ou un ou plusieurs acides faibles. Dans la mesure où cet agent de gravure présente un fort écart de vitesse de gravure entre la partie inférieure 11 dopée P+ et la partie supérieure 12 dopée P-, par exemple d'un rapport 50, voire d'un rapport 100, la partie inférieure 11 dopée P+ est supprimée uniquement et non pas la partie supérieure 12 dopée P-. De plus, dans la mesure où il y a une discontinuité spatiale du niveau de dopage suivant l'axe Z entre la partie inférieure 11 dopée P+ et les portions centrales 13 dopées P+, les portions centrales 13 dopées P+ ne sont pas gravées. A la suite de cette étape, le substrat de croissance 10 aminci présente l'épaisseur constante e_{ref} dans le plan XY, celle-ci étant supérieure strictement à l'épaisseur e₁₃ des portions centrales 13 dopées P+.

La figure 5F illustre une deuxième phase d'amincissement du substrat de croissance 10, permettant à la face arrière 10i du substrat 10 de déboucher sur les portions centrales 13 dopées P+. Cette phase d'amincissement peut être effectuée par une technique d'attaque chimique non sélective, humide ou sèche, ou par une technique de meulage. Dans la mesure où la différence est faible entre l'épaisseur e₁₃ des portions centrales 13 dopées P+ et l'épaisseur e_{ref} de la partie supérieure 12 dopée P-, par exemple de l'ordre de un micron à quelques microns, par exemple 1µm environ, cette deuxième phase d'amincissement n'est pas susceptible d'introduire des inhomogénéités d'épaisseur Δe_{xy} substantielles dans le substrat de croissance 10 aminci.

La figure 5G illustre la suppression des portions centrales 13 dopées P+ par gravure chimique sélective vis-à-vis des portions latérales 14 dopées P- et vis-à-vis ici de la couche de nucléation 23. L'agent de gravure peut être identique ou similaire à celui utilisé en référence à la figure 5E. Aussi, les portions centrales 13 dopées P+ sont gravées sur toute leur épaisseur, de sorte à rendre libre la surface inférieure de la couche de nucléation 23. On obtient ainsi les parois latérales 15 de maintien similaires ou identiques à celles décrites précédemment.

Les étapes suivantes du procédé de fabrication sont identiques ou similaires à celles décrites en référence aux figures 4B et 4C, et ne sont pas décrites à nouveau.

Ainsi, comme le procédé selon les premier et deuxième modes de réalisation, le procédé selon ce troisième mode permet, outre de limiter la dégradation structurelle du dispositif optoélectronique 1 en obtenant un substrat de croissance 10 aminci permettant de limiter les inhomogénéités d'épaisseur Δe_{xy}, de former les parois latérales 15 de maintien par gravure chimique sélective des portions centrales 13 dopées P+.

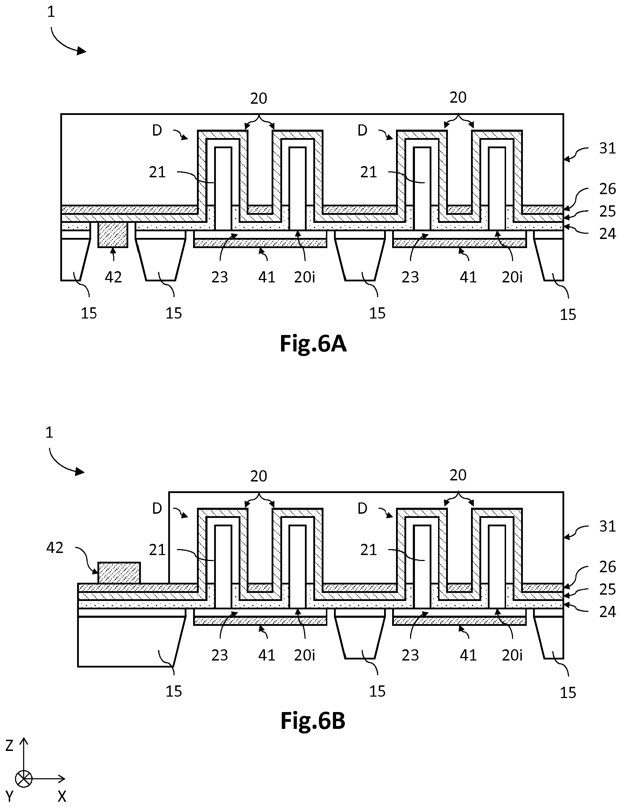

Les figures 6A et 6B illustrent deux variantes du dispositif optoélectronique 1 illustré sur la fig.4G. La variante représentée sur la fig.6A s'en distingue essentiellement en ce que la poignée 32 a été retirée et en ce que des portions de nucléation 23, issues de la couche de nucléation, sont conservées, le matériau de nucléation étant conducteur ou semiconducteur. Comme décrit précédemment en référence à la fig.3A, le matériau de nucléation peut comporter un métal de transition, et la portion de nucléation peut présenter une structure similaire ou identique à celle décrite dans la demande FR16/56008. Par ailleurs, la variante représentée sur la fig.6B se distingue du dispositif optoélectronique 1 de la fig.6A essentiellement en ce que le deuxième plot conducteur 42 repose sur la couche conductrice 26 et est ainsi en contact électrique avec la couche d'électrode 25.

Des modes de réalisation particuliers viennent d'être décrits. Différentes variantes et modifications apparaîtront à l'homme du métier.

Ainsi, on a décrit différents exemples d'un dispositif optoélectronique 1 à diodes électroluminescentes 20 obtenu par le procédé de réalisation, le dispositif optoélectronique 1 pouvant former avantageusement un écran d'affichage ou un projecteur d'image. Cependant, l'invention s'applique également au domaine des photodiodes 20 adaptées à recevoir et détecter un rayonnement lumineux incident et à le convertir en des signaux électriques.

On a décrit des diodes 20 de type filaire mais l'invention s'applique également aux éléments semiconducteurs tridimensionnels en forme de plots tridimensionnels dont la hauteur suivant l'axe Z est du même ordre de grandeur que ses dimensions transversales dans le plan XY, ainsi qu'aux éléments tridimensionnels en forme de pyramides éventuellement tronquées. Elle s'applique également aux diodes à structure en mesa. Par structure en mesa, on entend une structure formée d'un empilement de portions semiconductrices, formant une jonction PN, situées en saillie au-dessus du substrat de croissance à la suite d'une étape de gravure.

On a également décrit un substrat de croissance en un matériau semiconducteur dopé de type P mais l'invention s'applique également au matériau semiconducteur, par exemple le silicium, dopé de type N. Dans ce cas, la partie inférieure 11 est dopée de type N+ et la partie supérieure 12 est dopée de type N-. Dans le cadre du troisième mode de réalisation du procédé de fabrication, les portions centrales 13 peuvent être dopées de type N+.

## Revendications

1. Procédé de fabrication d'un dispositif optoélectronique (1), comportant les étapes suivantes :
a) fournir un substrat (10) dit de croissance en un matériau semiconducteur, comportant une face avant (10s) et une face arrière (10i) opposées l'une à l'autre ;
b) former, sur la face avant (10s), une pluralité de diodes (20), chaque diode (20) comportant une face inférieure (20i) reposant sur le substrat (10) ;
c) supprimer, à partir de la face arrière (10i), au moins une portion (12 ; 13) du substrat (10) de manière à rendre libre la face inférieure (20i) d'au moins une partie des diodes (20), la portion supprimée (12 ; 13) étant initialement située en regard de ladite partie de diodes (20) ;
le procédé étant **caractérisé en ce que** :
- l'étape a) comporte la réalisation d'une partie inférieure et d'une partie supérieure du substrat (10) s'étendant chacune en regard des diodes (20), lesdites parties (11, 12) étant dopées selon un même type de conductivité, la partie inférieure (11) présentant un premier niveau de dopage, et la partie supérieure (12) présentant un deuxième niveau de dopage inférieur au premier niveau et s'étendant à partir de la face avant (10s) jusqu'à la partie inférieure (11) avec une épaisseur (e_{ref}) homogène ;
- l'étape c) comportant une suppression de la partie inférieure (11) par gravure chimique sélective vis-à-vis de la partie supérieure (12).

2. Procédé selon la revendication 1, dans lequel l'étape c) comporte en outre une suppression par gravure chimique de la partie supérieure (12) du substrat (10), totale ou partielle dans un plan parallèle à la face avant (10s), de manière à rendre libre la face inférieure (20i) des diodes (20).

3. Procédé selon la revendication 1 ou 2, chaque diode comportant un élément semiconducteur (21) qui participe à former une jonction PN de la diode (20), la face inférieure (20i) de chaque diode (20) étant en contact électrique avec ledit élément semiconducteur (21), le procédé comportant une étape d) de formation d'au moins un premier plot conducteur (41) au contact de la face inférieure (20i) de ladite partie des diodes (20).

4. Procédé selon la revendication 3, dans lequel :
- lors de l'étape b), les diodes (20) sont réparties spatialement en une pluralité d'ensembles (D) distincts de diodes (20), chaque ensemble (D) étant destiné à former un pixel (Px) du dispositif optoélectronique (1) ;
- lors de l'étape d), une pluralité de premiers plots conducteurs (41) distincts est formée, chaque premier plot conducteur (41) étant au contact de la face inférieure (20i) des diodes (20) d'un même ensemble (D).

5. Procédé selon la revendication 4, dans lequel :
- la partie supérieure (12) comporte des portions dites centrales (13) séparées les unes des autres, dans un plan parallèle à la face avant (10s), par des portions dites latérales (14), chaque portion centrale (13) étant située en regard d'un ensemble (D) de diodes (20) et les portions latérales (14) étant situées entre les ensembles (D) de diodes (20) ; et
- l'étape c) comporte une suppression partielle de la partie supérieure (12), dans un plan parallèle à la face avant (10s), de manière à supprimer les portions centrales (13) et à conserver les portions latérales (14), lesquelles forment ainsi des parois latérales (15) de maintien.

6. Procédé selon la revendication 5, dans lequel, lors de l'étape c), les portions centrales (13) sont gravées par gravure humide ou sèche.

7. Procédé selon la revendication 5 ou 6, dans lequel :
- l'étape a) comporte la réalisation desdites portions centrales (13) par dopage localisé de la partie supérieure (12) de sorte que lesdites portions centrales (13) présentent un niveau de dopage égal ou supérieur au premier niveau de dopage et que les portions latérales (14) présentent le deuxième niveau de dopage, chaque portion centrale (13) étant séparée des portions centrales (13) adjacentes par l'une desdites portions latérales (14), et chaque portion centrale (13) présentant une épaisseur (e₁₃) strictement inférieure à l'épaisseur (e_{ref}) de la partie supérieure (12) ;
- l'étape c) comporte, à la suite de la suppression de la partie inférieure (11), une phase d'amincissement du substrat (10) de sorte que la face arrière (10i) débouche sur les portions centrales (13), puis la suppression des portions centrales (13) par gravure chimique sélective vis-à-vis des portions latérales (14), de manière à rendre libre la face inférieure (20i) des ensembles (D) de diodes (20), les portions latérales (14) formant ainsi des parois latérales (15) de maintien.

8. Procédé selon l'une quelconque des revendications 5 à 7, ladite épaisseur (e_{ref}) de la partie supérieure (12) étant comprise entre 0,5µm et 20µm, de sorte que, à la suite de l'étape c), les parois latérales (15) de maintien présentent une hauteur comprise entre 0,5µm et 20µm.

9. Procédé selon la revendication 4 à 8, dans lequel :
- l'étape b) comporte l'épitaxie des éléments semiconducteurs (21) à partir d'une couche de nucléation (23) réalisée en un matériau électriquement isolant ;
- l'étape c) comporte en outre la suppression de portions de la couche de nucléation (23), de sorte qu'à la suite de l'étape d), les premiers plots conducteurs (41) sont au contact d'une surface inférieure (21i) des éléments semiconducteurs (21) formant la face inférieure (20i) des diodes (20).

10. Procédé selon la revendication 4 à 8, dans lequel :
- l'étape b) comporte l'épitaxie des éléments semiconducteurs (21) à partir d'une couche de nucléation (23) réalisée en un matériau conducteur ou semiconducteur, les premiers plots conducteurs (41) étant, à la suite de l'étape d), au contact d'une surface inférieure de la couche de nucléation (23) formant la face inférieure (20i) des diodes (20).

11. Procédé selon l'une quelconque des revendications 1 à 10, dans lequel l'étape b) comporte le dépôt d'une couche d'électrode (25) conductrice et au moins partiellement transparente recouvrant toutes les diodes (20), et dans lequel un deuxième plot conducteur (42) est en contact électrique avec la couche d'électrode (25).

12. Procédé selon la revendication 11, dans lequel le deuxième plot conducteur (42) est situé du côté d'une surface dite inférieure de la couche d'électrode (25) orientée vers la face inférieure (20i), ou est situé du côté d'une surface dite supérieure de la couche d'électrode (25) opposée à la surface inférieure.

13. Procédé selon l'une quelconque des revendications 1 à 12, dans lequel l'étape b) comporte le dépôt d'une couche diélectrique (24) sur la face avant (10s) du substrat de croissance (10) ou sur une couche de nucléation (23), un ou des premiers plots conducteurs (41) étant au contact de la face inférieure (20i) des diodes (20), et étant électriquement isolés de la couche d'électrode (25) par la couche diélectrique (24).

14. Procédé selon l'une quelconque des revendications 1 à 13, dans lequel chaque diode (20) comporte un élément semiconducteur (21) tridimensionnel.

15. Procédé selon l'une quelconque des revendications 1 à 14, dans lequel le matériau semiconducteur du substrat (10) est du silicium dopé selon une conductivité de type P ou de type N.

## Patentansprüche

1. Verfahren zur Herstellung einer optoelektronischen Vorrichtung (1), das die folgenden Schritte aufweist:
a) Bereitstellen eines so genannten Wachstumssubstrats (10) aus einem Halbleitermaterial, das einander gegenüberliegend eine Vorderseite (10s) und eine Rückseite (10i) aufweist;
b) Formen, auf der Vorderseite (10s), einer Vielzahl von Dioden (20), wobei jede Diode (20) eine auf dem Substrat (10) ruhende Unterseite (20i) aufweist;
c) Entfernen, ausgehend von der Rückseite (10i), mindestens eines Abschnitts (12; 13) des Substrats (10), um die Unterseite (20i) von mindestens einem Teil der Dioden (20) freizugeben, wobei der entfernte Abschnitt (12; 13) sich ursprünglich gegenüber dem Teil von Dioden (20) befindet;
wobei das Verfahren **dadurch gekennzeichnet ist, dass**:
- der Schritt a) die Herstellung eines unteren Teils und eines oberen Teils des Substrats (10) aufweist, die sich je gegenüber den Dioden (20) erstrecken, wobei die Teile (11, 12) gemäß einem gleichen Leitfähigkeitstyp dotiert sind, wobei der untere Teil (11) einen ersten Dotierungspegel aufweist, und der obere Teil (12) einen zweiten Dotierungspegel niedriger als der erste Pegel aufweist und sich ausgehend von der Vorderseite (10s) bis zum unteren Teil (11) mit einer homogenen Dicke (e_{ref}) erstreckt;
- der Schritt c) ein Entfernen des unteren Teils (11) durch selektives chemisches Ätzen gegenüber dem oberen Teil (12) aufweist.

2. Verfahren nach Anspruch 1, wobei der Schritt c) außerdem ein Entfernen durch chemisches Ätzen des oberen Teils (12) des Substrats (10), ganz oder teilweise, in einer Ebene parallel zur Vorderseite (10s) aufweist, um die Unterseite (20i) der Dioden (20) freizugeben.

3. Verfahren nach Anspruch 1 oder 2, wobei jede Diode ein Halbleiterelement (21) aufweist, das daran mitwirkt, einen PN-Übergang der Diode (20) zu formen, wobei die Unterseite (20i) jeder Diode (20) mit dem Halbleiterelement (21) in elektrischem Kontakt ist, wobei das Verfahren einen Schritt d) des Formens mindestens eines ersten leitenden Blocks (41) in Kontakt mit der Unterseite (20i) des Teils der Dioden (20) aufweist.

4. Verfahren nach Anspruch 3, wobei:
- im Schritt b) die Dioden (20) räumlich in eine Vielzahl von verschiedenen Einheiten (D) von Dioden (20) aufgeteilt werden, wobei jede Einheit (D) dazu bestimmt ist, ein Pixel (Px) der optoelektronischen Vorrichtung (1) zu formen;
- im Schritt d) eine Vielzahl von verschiedenen ersten leitenden Blöcken (41) geformt wird, wobei jeder erste leitende Block (41) mit der Unterseite (20i) der Dioden (20) einer gleichen Einheit (D) in Kontakt ist.

5. Verfahren nach Anspruch 4, wobei:
- der obere Teil (12) so genannte zentrale Abschnitte (13) aufweist, die voneinander in einer Ebene parallel zur Vorderseite (10s) durch so genannte seitliche Abschnitte (14) getrennt sind, wobei jeder zentrale Abschnitt (13) sich gegenüber einer Einheit (D) von Dioden (20) befindet und die seitlichen Abschnitte (14) sich zwischen den Einheiten (D) von Dioden (20) befinden; und
- der Schritt c) ein teilweises Entfernen des oberen Teils (12) in einer Ebene parallel zur Vorderseite (10s) aufweist, um die zentralen Abschnitte (13) zu entfernen und die seitlichen Abschnitte (14) beizubehalten, die so seitliche Haltewände (15) formen.

6. Verfahren nach Anspruch 5, wobei im Schritt c) die zentralen Abschnitte (13) durch Nass- oder Trockenätzen geätzt werden.

7. Verfahren nach Anspruch 5 oder 6, wobei:
- der Schritt a) die Herstellung der zentralen Abschnitte (13) durch lokales Dotieren des oberen Teils (12) aufweist, so dass die zentralen Abschnitte (13) einen Dotierungspegel gleich dem oder größer als der erste Dotierungspegel aufweisen, und dass die seitlichen Abschnitte (14) den zweiten Dotierungspegel aufweisen, wobei jeder zentrale Abschnitt (13) von den benachbarten zentralen Abschnitten (13) durch einen der seitlichen Abschnitte (14) getrennt ist, und jeder zentrale Abschnitt (13) eine Dicke (e₁₃) strikt geringer als die Dicke (e_{ref}) des oberen Teils (12) aufweist;
- der Schritt c) nach dem Entfernen des unteren Teils (11) eine Phase der Verdünnung des Substrats (10), so dass die Rückseite (10i) auf die zentralen Abschnitte (13) mündet, dann das Entfernen der zentralen Abschnitte (13) durch selektives chemisches Ätzen gegenüber den seitlichen Abschnitten (14) aufweist, um die Unterseite (20i) der Einheiten (D) von Dioden (20) freizugeben, wobei die seitlichen Abschnitte (14) so seitliche Haltewände (15) formen.

8. Verfahren nach einem der Ansprüche 5 bis 7, wobei die Dicke (e_{ref}) des oberen Teils (12) zwischen 0,5 µm und 20 µm liegt, so dass nach dem Schritt c) die seitlichen Haltewände (15) eine Höhe zwischen 0,5 µm und 20 µm aufweisen.

9. Verfahren nach Anspruch 4 bis 8, wobei:
- der Schritt b) die Epitaxie der Halbleiterelemente (21) ausgehend von einer Keimbildungsschicht (23) aufweist, die aus einem elektrisch isolierenden Material hergestellt ist;
- der Schritt c) außerdem das Entfernen von Abschnitten der Keimbildungsschicht (23) aufweist, so dass nach dem Schritt d) die ersten leitenden Blöcke (41) mit einer unteren Fläche (21i) der Halbleiterelemente (21) in Kontakt sind, die die Unterseite (20i) der Dioden (20) formt.

10. Verfahren nach Anspruch 4 bis 8, wobei:
- der Schritt b) die Epitaxie der Halbleiterelemente (21) ausgehend von einer Keimbildungsschicht (23) aufweist, die aus einem leitenden oder halbleitenden Material hergestellt ist, wobei die ersten leitenden Blöcke (41) nach dem Schritt d) mit einer unteren Fläche der Keimbildungsschicht (23) in Kontakt sind, die die Unterseite (20i) der Dioden (20) formt.

11. Verfahren nach einem der Ansprüche 1 bis 10, wobei der Schritt b) das Aufbringen einer leitenden und mindestens teilweise transparenten Elektrodenschicht (25) aufweist, die alle Dioden (20) bedeckt, und wobei ein zweiter leitender Block (42) mit der Elektrodenschicht (25) in Kontakt ist.

12. Verfahren nach Anspruch 11, wobei der zweite leitende Block (42) sich auf der Seite einer zur Unterseite (20i) ausgerichteten so genannten unteren Fläche der Elektrodenschicht (25) befindet, oder sich auf der Seite einer so genannten oberen Fläche der Elektrodenschicht (25) entgegengesetzt zur unteren Fläche befindet.

13. Verfahren nach einem der Ansprüche 1 bis 12, wobei der Schritt b) das Aufbringen einer dielektrischen Schicht (24) auf die Vorderseite (10s) des Wachstumssubstrats (10) oder auf eine Keimbildungsschicht (23) aufweist, wobei einer oder mehrere erste leitende Blöcke (41) mit der Unterseite (20i) der Dioden (20) in Kontakt und durch die dielektrische Schicht (24) von der Elektrodenschicht (25) elektrisch isoliert ist/sind.

14. Verfahren nach einem der Ansprüche 1 bis 13, wobei jede Diode (20) ein dreidimensionales Halbleiterelement (21) aufweist.

15. Verfahren nach einem der Ansprüche 1 bis 14, wobei das Halbleitermaterial des Substrats (10) gemäß einer Leitfähigkeit des Typs P oder des Typs N dotiertes Silicium ist.

## Claims

1. Method for fabricating an optoelectronic device (1), comprising the following steps:
a) supplying a so-called growth substrate (10) made of a semiconductor material, comprising a front face (10s) and a rear face (10i) opposite one another;
b) forming, on the front face (10s), a plurality of diodes (20), each diode (20) comprising a lower face (20i) resting on the substrate (10);
c) removing, from the rear face (10i), at least one portion (12; 13) of the substrate (10) so as to free the lower face (20i) of at least a part of the diodes (20), the portion removed (12; 13) being initially located opposite said part of diodes (20);
the method being **characterized in that**:
- step a) comprises producing a lower part and an upper part of the substrate (10) each extending opposite the diodes (20), said parts (11, 12) being doped according to one and the same type of conductivity, the lower part (11) having a first doping level, and the upper part (12) having a second doping level lower than the first level and extending from the front face (10s) to the lower part (11) with a uniform thickness (e_{ref});
- step c) comprising removing the lower part (11) by selective chemical etching with respect to the upper part (12).

2. Method according to Claim 1, in which step c) further comprises complete or partial removal of the upper part (12) of the substrate (10) by chemical etching, in a plane parallel to the front face (10s), so as to free the lower face (20i) of the diodes (20).

3. Method according to Claim 1 or 2, each diode comprising a semiconducting element (21) which participates in forming a p-n junction of the diode (20), the lower face (20i) of each diode (20) being in electrical contact with said semiconducting element (21), the method comprising a step d) of forming at least one first conductive stud (41) in contact with the lower face (20i) of said part of the diodes (20).

4. Method according to Claim 3, in which:
- in step b), the diodes (20) are distributed spatially as a plurality of separate assemblies (D) of diodes (20), each assembly (D) being intended to form a pixel (Px) of the optoelectronic device (1);
- in step d), a plurality of separate first conductive studs (41) is formed, each first conductive stud (41) being in contact with the lower face (20i) of the diodes (20) of one and the same assembly (D).

5. Method according to Claim 4, in which:
- the upper part (12) comprises so-called central portions (13) separated from one another, in a plane parallel to the front face (10s), by so-called lateral portions (14), each central portion (13) being located opposite an assembly (D) of diodes (20) and the lateral portions (14) being located between the assemblies (D) of diodes (20); and
- step c) comprises partial removal of the upper part (12), in a plane parallel to the front face (10s), so as to remove the central portions (13) and preserve the lateral portions (14), which thus form retaining side walls (15).

6. Method according to Claim 5, in which, in step c), the central portions (13) are etched by wet or dry etching.

7. Method according to Claim 5 or 6, in which:
- step a) comprises producing said central portions (13) by localized doping of the upper part (12) in such a way that said central portions (13) have a doping level greater than or equal to the first doping level and so that the lateral portions (14) have the second doping level, each central portion (13) being separated from the adjacent central portions (13) by one of said lateral portions (14), and each central portion (13) having a thickness (e₁₃) strictly less than the thickness (e_{ref}) of the upper part (12);
- step c) comprises, following removal of the lower part (11), a step of thinning the substrate (10) so that the rear face (10i) opens onto the central portions (13), then removing the central portions (13) by selective chemical etching with respect to the lateral portions (14), so as to free the lower face (20i) of the assemblies (D) of diodes (20), the lateral portions (14) thus forming retaining side walls (15).

8. Method according to any one of Claims 5 to 7, said thickness (e_{ref}) of the upper part (12) being between 0.5µm and 20µm, so that, at the end of step c), the retaining side walls (15) have a height between 0.5µm and 20µm.

9. Method according to Claims 4 to 8, in which:
- step b) comprises epitaxy of the semiconducting elements (21) starting from a nucleation layer (23) made of an electrically insulating material;
- step c) further comprises removing portions of the nucleation layer (23), so that at the end of step d), the first conductive studs (41) are in contact with a lower surface (21i) of the semiconducting elements (21) forming the lower face (20i) of the diodes (20).

10. Method according to Claims 4 to 8, in which:
- step b) comprises epitaxy of the semiconducting elements (21) starting from a nucleation layer (23) made of a conductive or semiconducting material, the first conductive studs (41) being, at the end of step d), in contact with a lower surface of the nucleation layer (23) forming the lower face (20i) of the diodes (20).

11. Method according to any one of Claims 1 to 10, in which step b) comprises depositing a conductive electrode layer (25), at least partially transparent, covering all the diodes (20), and in which a second conductive stud (42) is in electrical contact with the electrode layer (25).

12. Method according to Claim 11, in which the second conductive stud (42) is located on the side of a so-called lower surface of the electrode layer (25) oriented toward the lower face (20i), or is located on the side of a so-called upper surface of the electrode layer (25) opposite the lower surface.

13. Method according to any one of Claims 1 to 12, in which step b) comprises depositing a dielectric layer (24) on the front face (10s) of the growth substrate (10) or on a nucleation layer (23), one or more first conductive studs (41) being in contact with the lower face (20i) of the diodes (20), and being electrically insulated from the electrode layer (25) by the dielectric layer (24).

14. Method according to any one of Claims 1 to 13, in which each diode (20) comprises a three-dimensional semiconducting element (21).

15. Method according to any one of Claims 1 to 14, in which the semiconducting material of the substrate (10) is silicon doped with p-type or n-type conductivity.
